(19) Europäisches Patentamt
European Patent Office
Office européen des brevets

(11) **EP 3 081 948 A1**

(12) **DEMANDE DE BREVET EUROPEEN**

(43) Date de publication:
**19.10.2016 Bulletin 2016/42**

(51) Int Cl.:
**G01R 17/06** (2006.01)    **G01R 19/00** (2006.01)

(21) Numéro de dépôt: **15163750.1**

(22) Date de dépôt: **15.04.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA**

(71) Demandeur: **General Electric Technology GmbH 5400 Baden (CH)**

(72) Inventeur: **Dupraz, Jean-Pierre 01360 BRESSOLLES (FR)**

(74) Mandataire: **Brevalex 95, rue d'Amsterdam 75378 Paris Cedex 8 (FR)**

(54) **MESURE ET EQUILIBRAGE DE COURANT**

(57)    Dispositif de mesure d'un courant de charge traversant au moins un transistor (T1),
caractérisé en ce qu'il comporte :
- une première branche (B1) reliée entre une électrode de sortie de l'au moins un transistor et un point de référence de tension (PR1), la première branche comportant au moins un premier transistor de commande (T2),
- une deuxième branche (B2) reliée en parallèle de la première branche, la deuxième branche (B2) comportant au moins un deuxième transistor de commande (T3) en série avec un circuit de mesure de courant (Rs).

FIG. 1a

EP 3 081 948 A1

**Description**

**DOMAINE TECHNIQUE**

La présente invention concerne la mesure d'un courant de charge présent sur l'une des électrodes de sortie d'un transistor. Elle concerne corrélativement l'équilibrage de courant dans des branches parallèles comportant chacune au moins un transistor.

Cette mesure et cet équilibrage de courant sont utilisables en particulier dans un dispositif disjoncteur mécatronique tel que décrit et revendiqué dans FR 11 62413.

**ÉTAT DE LA TECHNIQUE ANTÉRIEURE**

Dans de nombreuses applications mettant en jeu de l'électronique de puissance, il est nécessaire de mettre en parallèle plusieurs sous-systèmes afin de maintenir le courant traversant chacun d'eux à un niveau compatible avec les caractéristiques de leurs constituants. Ce problème est particulièrement délicat dans le cas de systèmes devant présenter de très faibles pertes d'insertion lorsqu'ils sont traversés par un courant important, par exemple de plusieurs milliers d'Ampères.

Si aucune précaution n'est prise, la répartition du courant entre les différents sous-systèmes se fait en fonction des impédances et des tensions de seuil présentées par chacun d'eux. Dans la pratique, les impédances et les tensions de seuil des semi-conducteurs de puissance sont très dispersées d'un composant à l'autre, même dans des conditions d'utilisation identiques. Cela implique que les courants dans les différents sous-systèmes connectés en parallèle sont eux aussi très dispersés, dans des proportions pouvant atteindre et dépasser le simple au double. Cela conduit, dans une solution de l'art antérieur, à sur-dimensionner les sous-systèmes pour qu'ils supportent les valeurs de courant les plus grandes.

Un tel surdimensionnement a pour inconvénient d'augmenter le coût et l'encombrement du système hôte au point de risquer de le rendre non viable.

Une solution à ce problème, et faisant l'objet de la présente invention, consiste à mesurer les courants circulant dans chaque sous système, et à les asservir à une valeur moyenne calculée à partir du courant total.

Mais la mesure de tels courants, dans l'art antérieur, n'est pas satisfaisante. En effet, la mesure du courant circulant dans un transistor de puissance, qu'il s'agisse du courant collecteur ou du courant d'émetteur, dans le cas d'un transistor bipolaire ou d'un IGBT (insulated-gate bipolar transistor), ou du courant de drain dans le cas d'un transistor de type MOSFET (Metal Oxide Semiconductor Field Effect Transistor) de puissance, peut devenir une mission compliquée lorsqu'une ou plusieurs contraintes sont réunies. Parmi ces contraintes, on peut citer les suivantes :

- Courant de type continu,
- Courant important, de plusieurs dizaines d'ampères,
- Environnement électromagnétique perturbé,
- Grande densité de composants restreignant l'encombrement autorisé du capteur,
- Ultra faible consommation requise en raison des capacités limitées de l'alimentation locale,
- Précision élevée requise, meilleure que le « pourcent ».

Il existe traditionnellement deux solutions pour effectuer une telle mesure :

- Utilisation d'un shunt de courant,
- Utilisation de capteur de courant à flux nul.

La première solution conduit à un mauvais compromis entre la précision de mesure qui requiert un certain niveau de chute de tension aux bornes du shunt, les pertes Joules engendrées dans ce shunt, l'encombrement nécessaire au maintien de l'échauffement du shunt à un niveau acceptable, et la stabilité thermique du shunt qui nécessite d'une part une technologie appropriée, comme par exemple une technologie Nickel Chrome, et une dimension suffisante du shunt.

La seconde solution conduit à une importante consommation d'énergie électrique, puisque les capteurs de courant à flux nul nécessitent une électronique de contre réaction qu'il faut bien alimenter. Par ailleurs, ces capteurs sont relativement encombrants, et, lorsque plusieurs courants doivent être mesurés, ils peuvent induire un surdimensionnement de l'équipement hôte.

**EXPOSÉ DE L'INVENTION**

L'invention vise à résoudre les problèmes de la technique antérieure en fournissant un dispositif de mesure d'un courant de charge traversant au moins un transistor,

caractérisé en ce qu'il comporte :

- une première branche reliée entre une électrode de sortie de l'au moins un transistor et un point de référence de tension, la première branche comportant au moins un premier transistor de commande,
- une deuxième branche reliée en parallèle de la première branche, la deuxième branche comportant au moins un deuxième transistor de commande en série avec un circuit de mesure de courant.

L'invention permet d'effectuer une mesure précise du courant circulant dans un transistor, que ce courant soit de type courant continu ou de type courant alternatif périodique.

Selon l'invention, la mesure du courant est effectuée au moyen d'une résistance de précision insérée dans le circuit pendant une durée limitée à celle nécessaire à la mesure, cette insertion étant effectuée via un ensemble de transistors pilotés selon une séquence adaptée.

Selon une caractéristique préférée, le dispositif de mesure d'un courant de charge comporte en outre :

- une troisième branche reliée en parallèle des première et deuxième branches, la troisième branche comportant au moins un condensateur, au moins une diode et au moins une résistance.

Selon une caractéristique préférée, le dispositif de mesure d'un courant de charge comporte en outre :

- une quatrième branche reliée en parallèle des première et deuxième branches, la quatrième branche comportant un circuit de limitation de tension.

Selon une caractéristique préférée, le dispositif de mesure d'un courant de charge comporte en outre :

- une cinquième branche reliée en parallèle de l'ensemble formé par l'au moins un transistor et les branches qui lui sont connectées en série, la cinquième branche comportant au moins un condensateur, une diode et au moins une résistance.

Selon une caractéristique préférée, le dispositif de mesure d'un courant de charge comporte en outre :

- une sixième branche reliée en parallèle de l'ensemble formé par l'au moins un transistor et les branches qui lui sont connectées en série, la sixième branche comportant un circuit de limitation de tension.

Selon une caractéristique préférée, le dispositif de mesure d'un courant de charge comporte en outre :

- au moins une diode de roue libre reliée en parallèle de l'ensemble formé par l'au moins un transistor et les branches qui lui sont connectées en série.

L'invention concerne aussi un dispositif d'équilibrage de courant dans des branches parallèles comportant chacune un transistor, chaque transistor étant commandé par une tension de commande respective,

caractérisé en ce qu'il comporte :

- un dispositif de mesure d'un courant de charge selon l'une quelconque des revendications 1 à 5, respectivement associé à chaque branche,
- un moyen de commande d'une mesure simultanée du courant de chaque branche,
- un moyen de calcul d'un courant d'équilibre en fonction du courant mesuré dans chaque branche,
- un moyen de comparaison entre une valeur représentative du courant mesuré dans chaque branche et le courant d'équilibre,
- un moyen de pilotage des tensions de commande en fonction du résultat de la comparaison pour chaque branche.

L'invention permet ainsi de déduire de la mesure du courant circulant dans un transistor une stratégie de contrôle du taux de conduction du transistor. L'invention permet d'assurer un partage équilibré du courant lorsque plusieurs branches identiques ou similaires contenant un tel transistor sont montées en parallèle pour assurer le transfert d'un courant important.

Selon une caractéristique préférée, le dispositif d'équilibrage de courant alternatif dans des branches parallèles comporte :

- un moyen de synchronisation adapté à commander la mesure de courant de chaque branche à un instant voisin d'un extrémum de courant.

L'invention concerne aussi un dispositif de surveillance de circuits électriques dans des branches parallèles comportant chacune un transistor, chaque transistor étant commandé par une tension de commande respective, caractérisé en ce qu'il comporte :

- un dispositif de mesure d'un courant de charge selon l'une quelconque des revendications 1 à 5, respectivement associé à chaque branche,
- un moyen de commande d'une mesure simultanée du courant de chaque branche,
- un moyen de calcul d'un courant d'équilibre en fonction du courant mesuré dans chaque branche,
- un moyen de comparaison entre une valeur représentative du courant mesuré dans chaque branche et le courant d'équilibre,
- un moyen d'émission d'un signal d'anomalie en fonction du résultat de la comparaison effectuée par le moyen de comparaison.

L'invention permet encore de détecter, via la comparaison des courants circulant dans chacune des branches destinées à se partager un courant important via leur mise en parallèle, une anomalie ou défaillance de l'un ou plusieurs de leurs constituants.

L'invention concerne aussi un procédé de mesure d'un courant de charge traversant au moins un transistor, caractérisé en ce qu'il comporte les étapes de :

- blocage d'au moins un premier transistor de commande inclus dans une première branche reliée entre une électrode de sortie du transistor et un point de référence de tension, au moins un deuxième transistor de commande dans une deuxième branche reliée en parallèle de la première branche étant préalablement en conduction,
- mesure du courant traversant la deuxième branche, par un circuit de mesure de courant relié en série avec l'au moins un deuxième transistor de commande de la deuxième branche, et
- mise en conduction de l'au moins un premier transistor de commande de la première branche.

L'invention concerne aussi un procédé de mesure d'un courant de charge traversant au moins un transistor, caractérisé en ce qu'il comporte les étapes de :

- mise en conduction d'au moins un deuxième transistor de commande dans une deuxième branche reliée entre une électrode de sortie du transistor et un point de référence de tension,
- blocage d'au moins un premier transistor de commande inclus dans une première branche reliée en parallèle de la deuxième branche,
- mesure du courant traversant la deuxième branche, par un circuit de mesure de courant relié en série avec l'au moins un deuxième transistor de commande de la deuxième branche,
- mise en conduction de l'au moins un premier transistor de commande de la première branche, et
- blocage de l'au moins un deuxième transistor de commande de la deuxième branche.

L'invention concerne aussi un procédé d'équilibrage de courant dans des branches parallèles comportant chacune un transistor, chaque transistor étant commandé par une tension de commande respective, caractérisé en ce qu'il comporte les étapes de :

- commande d'une mesure simultanée du courant de chaque branche, selon le procédé de mesure tel que précédemment présenté, respectivement appliqué à chaque branche,
- calcul d'un courant d'équilibre en fonction du courant mesuré dans chaque branche,
- comparaison entre une valeur représentative du courant mesuré dans chaque branche et le courant d'équilibre,
- pilotage des tensions de commande en fonction du résultat de la comparaison pour chaque branche.

L'invention concerne aussi un procédé de surveillance de circuits électriques dans des branches parallèles comportant chacune un transistor, chaque transistor étant commandé par une tension de commande respective, caractérisé en ce qu'il comporte les étapes de :

- commande d'une mesure simultanée du courant de chaque branche, selon le procédé de mesure tel que précédemment présenté, respectivement appliqué à chaque branche,
- calcul d'un courant d'équilibre en fonction du courant mesuré dans chaque branche,
- comparaison entre une valeur représentative du courant mesuré dans chaque branche et le courant d'équilibre,
- émission d'un signal d'anomalie en fonction du résultat de la comparaison effectuée par le moyen de comparaison.

Les procédés présentent des avantages analogues à ceux précédemment présentés.

Dans un mode particulier de réalisation, les étapes du procédé selon l'invention sont mises en oeuvre par des instructions de programme d'ordinateur ou d'automate, ou par des circuits logiques programmables tels que des FPGA ou leurs équivalents.

En conséquence, l'invention vise aussi un programme d'ordinateur sur un support d'informations, ce programme étant susceptible d'être mis en oeuvre dans un ordinateur ou un automate, ou par des circuits logiques programmables tels que des FPGA ou leurs équivalents, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable comme par exemple la configuration de circuits électriques au sein de circuits logiques programmables tels que des FPGA ou leurs équivalents.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

## BRÈVE DESCRIPTION DES DESSINS

D'autres caractéristiques et avantages apparaîtront à la lecture de la description suivante d'un mode de réalisation préféré donné à titre d'exemple non limitatif, décrit en référence aux figures dans lesquelles :

Les figures 1a et 1b représentent un dispositif de mesure de courant traversant un transistor, selon deux modes de réalisation de l'invention,

Les figures 2a et 2b représentent deux modes de réalisation d'un procédé de mesure de courant mis en oeuvre dans les dispositifs des figures 1a et 1b,

La figure 3 représente un dispositif d'équilibrage de courant dans des branches parallèles comportant chacune un transistor, selon un mode de réalisation de l'invention,

La figure 4 représente un procédé d'équilibrage de courant dans des branches parallèles comportant chacune un transistor, selon un mode de réalisation de l'invention,

La figure 5 représente un procédé d'équilibrage de courant dans des branches parallèles comportant chacune un transistor, selon un autre mode de réalisation de l'invention,

La figure 6 représente un procédé de surveillance de contacts électriques présents dans les branches parallèles du système de la figure 3, selon un mode de réalisation de l'invention,

La figure 7 représente un procédé d'équilibrage de courant et de surveillance de contacts électriques présents dans les branches parallèles du système de la figure 3, selon un mode de réalisation de l'invention.

## EXPOSÉ DÉTAILLÉ DE MODES DE RÉALISATION PARTICULIERS

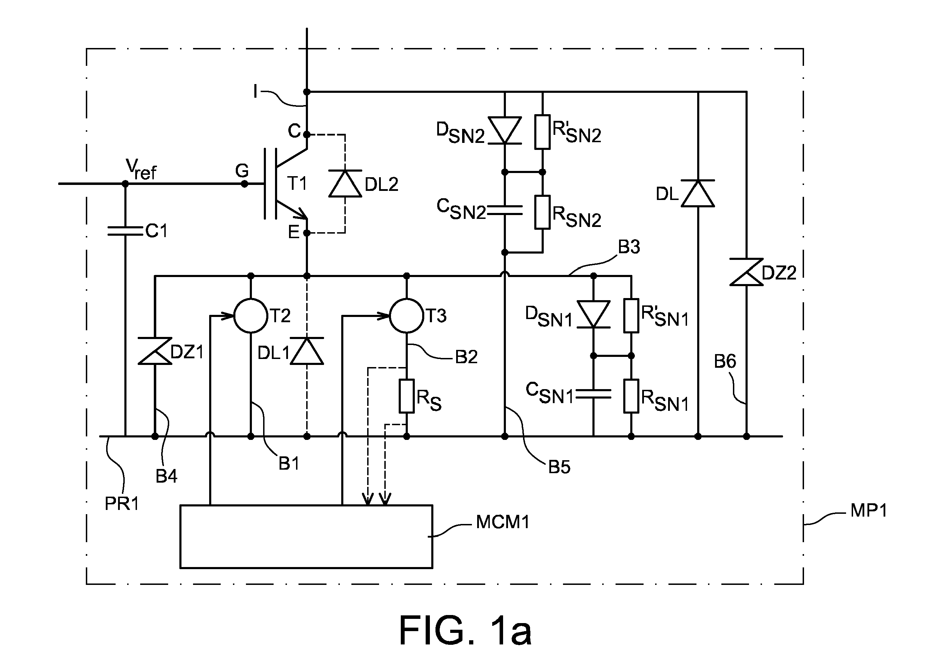

Selon un mode de réalisation préféré représenté à la **figure 1a,** un dispositif de mesure de courant est prévu pour mesurer le courant I qui traverse un transistor T1 faisant partie d'un module de puissance MP1. Le courant I est dit courant de charge, c'est un courant circulant dans un circuit non représenté. Le courant I peut être alternatif ou continu. Le transistor T1 peut être formé de l'association de plusieurs transistors connectés en parallèle et/ou en série.

Le transistor est par exemple un transistor de puissance de type IGBT. Le courant traverse alors le transistor T1 depuis son collecteur C vers son émetteur E.

La grille G du transistor T1 est reliée à un point PR1 de référence de tension via un condensateur C1. Une tension de référence V<sub>ref</sub>, issue d'une source non représentée, est appliquée à la grille G du transistor via le condensateur C1. Le condensateur C1 assure un stockage local de charges et présente une faible impédance pour les courantes hautes fréquences pouvant le traverser. Bien entendu, l'invention n'est pas limitée aux transistors de type IGBT.

Le dispositif de mesure du courant I comporte une première branche B1 reliée entre l'émetteur E du transistor T1 et le point de référence de tension PR. La première branche B1 comporte un premier transistor de commande T2. Il s'agit par exemple d'un transistor de type MOSFET, basse tension et fort courant. En variante, il s'agit de plusieurs transistors, de préférence identiques, et montés en parallèle.

Le dispositif de mesure du courant I comporte une deuxième branche B2 reliée en parallèle de la première branche. La deuxième branche B2 comporte un deuxième transistor de commande T3 en série avec un circuit de mesure de courant. Le circuit de mesure comporte essentiellement une résistance de mesure $R_s$.

Le transistor de commande T3 est similaire au transistor T2. Il s'agit également par exemple d'un transistor de type MOSFET, et il peut s'agir de plusieurs transistors, de préférence identiques, et montés en parallèle.

Le dispositif de mesure du courant I comporte une troisième branche B3 reliée en parallèle des première et deuxième branches. La troisième branche B3 comporte au moins un condensateur, au moins une diode et au moins une résistance.

Selon différentes variantes de réalisation, la troisième branche B3 comporte :

- un condensateur, relié en série à une sous-branche comportant une diode et une résistance montés en parallèle.
- un condensateur avec une résistance en parallèle, formant une sous-branche en série de laquelle est reliée une diode.
- un condensateur avec une résistance en parallèle, formant une sous-branche en série de laquelle est reliée une autre sous branche comportant une résistance et une diode en parallèle.

Dans le mode de réalisation représenté, la troisième branche B3 comporte à partir du point de référence de tension PR1 un condensateur $C_{SN1}$ avec une résistance $R_{SN1}$ en parallèle. Elle comporte aussi en série de cet ensemble une diode $D_{SN1}$ avec une résistance $R'_{SN1}$ en parallèle. La diode $D_{SN1}$ a sa cathode reliée au condensateur $C_{SN1}$ et son anode reliée à l'émetteur E du transistor T1.

La fonction de cette troisième branche est d'une part d'améliorer la phase de blocage du transistor T1, en protégeant les transistors T2 et T3 lors de leur blocage, via une limitation de la vitesse de croissance de la tension à leurs bornes. La fonction de cette troisième branche est d'autre part, dans cette même phase de blocage du transistor T1, de stocker une tension aux bornes du condensateur CSN1, tension qui, dans un mode de réalisation qui sera détaillé par la suite, permettra de polariser négativement la grille du transistor T1 par rapport à son émetteur.

Le dispositif de mesure du courant I comporte une quatrième branche B4 reliée en parallèle des première et deuxième branches, la quatrième branche B4 comportant un circuit de limitation de tension.

Le circuit de limitation de tension comporte au moins un composant non linéaire préférentiellement de type TVS (d'après l'anglais Transient Voltage Suppressor), comme par exemple une diode Zener de puissance DZ1. En variante, il s'agit d'un composant de type varistance.

Le dispositif de mesure du courant I comporte une cinquième branche B5 reliée en parallèle de l'ensemble formé par le transistor T1 et les branches qui lui sont connectées en série. La cinquième branche B5 comporte au moins un condensateur, une diode et au moins une résistance. Comme dans le cas de la troisième branche, différentes variantes de réalisation sont possibles, avec une résistance en parallèle avec le condensateur ou la diode, ou deux résistances, respectivement en parallèle avec le condensateur et la diode.

Dans le mode de réalisation préférentiel représenté, la cinquième branche B5 comporte à partir du point de référence de tension PR1 un condensateur $C_{SN2}$ avec une résistance $R_{SN2}$ en parallèle. Elle comporte aussi en série de cet ensemble une diode $D_{SN2}$ avec une résistance $R'_{SN2}$ en parallèle. La diode $D_{SN2}$ a sa cathode reliée au condensateur $C_{SN2}$ et son anode reliée au collecteur C du transistor T1.

La fonction de cette cinquième branche est de limiter, à une valeur inférieure à une limite supportable par le composant, la vitesse de croissance de la tension apparaissant entre le collecteur et l'émetteur du transistor T1 lors de son blocage. Cette limitation est aussi utile pour limiter l'effet du blocage du transistor T1 sur le circuit de commande de sa grille, en raison des charges injectées par effet Miller.

Dans le mode de réalisation préférentiel représenté, le dispositif de mesure du courant I comporte une sixième branche B6 reliée en parallèle de l'ensemble formé par le transistor T1 et les branches qui lui sont connectées en série. La sixième branche comporte un circuit de limitation de tension.

Le circuit de limitation de tension comporte au moins un composant non linéaire préférentiellement de type TVS (d'après l'anglais Transient Voltage Suppressor), comme par exemple une ou plusieurs diodes Zener de puissance DZ2. En variante, il s'agit d'un ou plusieurs composants de type varistance.

Le dispositif de mesure du courant I comporte en outre au moins une diode de roue libre reliée en parallèle du transistor T1 et des première et deuxième branches.

Cette diode permet la circulation du courant lorsque celui est d'une polarité inverse de la polarité que peut conduire le transistor T1. On rappelle que le courant I peut être alternatif ou continu. Dans le cas d'un courant alternatif, la partie négative du courant circule essentiellement via la diode DL. La mesure de courant s'applique alors à la partie positive du courant alternatif.

Selon une première variante, une unique diode de roue libre DL a sa cathode reliée au collecteur C du transistor T1 et son anode reliée au point de référence de tension PR.

Selon une seconde variante représentée en pointillés à la figure 1a, une première diode de roue libre DL1 a sa cathode reliée à l'émetteur E du transistor T1 et son anode reliée au point de référence de tension PR1. Une seconde diode de roue libre DL2 a sa cathode reliée au collecteur C du transistor T1 et son anode reliée à l'émetteur E du transistor T1.

Selon une variante non représentée, la diode DL1 peut être omise si les transistors T2 et T3 ont la propriété de conduire le courant dans les deux directions, comme c'est le cas pour certains transistors de type MOSFET.

Un module de commande et de mesure MCM1 pilote les transistors de commande T2 et T3 et reçoit un signal représentatif du courant mesuré au niveau de la résistance de mesure $R_s$.

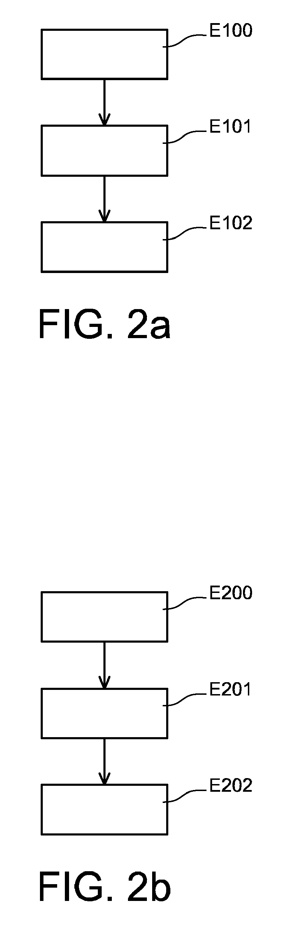

Le fonctionnement du module de commande et de mesure MCM1 en ce qui concerne la mesure de courant est décrit aux figures 2a et 2b sous la forme d'algorithmes.

Selon un premier mode de réalisation représenté à la **figure 2a,** les transistors T1, T2 et T3 sont tout d'abord en conduction.

Pour mesurer le courant traversant le transistor T1, le module de commande et de mesure MCM1 commande à une étape E100 le transistor T2 pour qu'il se bloque. Le courant traversant le transistor T1 traverse alors la deuxième branche B2, et donc la résistance $R_s$.

Après un délai nécessaire pour stabiliser le courant dans la résistance $R_s$, la mesure de courant est effectuée à une étape E101.

La mesure en elle-même est classique, elle comporte un échantillonnage suivi d'une mémorisation et d'une conversion analogique-numérique.

La durée nécessaire à la mesure, ou plus exactement à l'échantillonnage, est très courte, typiquement de quelques microsecondes.

Après la mesure de courant, le transistor T2 est commandé pour être à nouveau en conduction à une étape E102. Les transistors T1, T2 et T3 sont alors à nouveau en conduction, comme dans leur état initial avant la mesure de courant.

Selon un second mode de réalisation de mesure de courant traversant le transistor T1, représenté à la **figure 2b,** les transistors T1 et T2 sont tout d'abord en conduction. Le transistor T3 est bloqué.

Pour mesurer le courant, le module de commande et de mesure MCM1 commande à une étape E200 le transistor T3 pour être en conduction puis le transistor T2 pour qu'il se bloque. Le courant traversant le transistor T1 traverse alors la deuxième branche B2, et donc la résistance $R_s$.

Après un délai nécessaire pour stabiliser le courant dans la résistance $R_s$, la mesure de courant est effectuée à une étape E201.

Après la mesure de courant, le transistor T2 est commandé pour être à nouveau en conduction puis le transistor T3 est commandé pour être bloqué, à une étape E202. Les transistors T1 et T2 sont alors à nouveau en conduction et le transistor T3 est bloqué, comme dans leur état initial avant la mesure de courant.

L'avantage de ce mode de réalisation est qu'en régime permanent, aucun courant ne traverse la résistance $R_s$. Il n'y a donc aucun échauffement de la résistance de mesure $R_s$ qui reste à la température ambiante. Un courant traverse la résistance $R_s$ uniquement pendant la durée de la mesure, soit une durée très réduite.

Les transistors T2 et T3 ont également pour fonction de commander le transistor T1. Par exemple pour bloquer le transistor T1, le module de commande et de mesure MCM1 commande le blocage du transistor T3 puis commande le blocage du transistor T2. Le courant I circule alors dans la troisième branche B3 pendant une certaine durée. La tension aux bornes du condensateur $C_{SN1}$ augmente et la tension entre la grille G et l'émetteur E du transistor T1 diminue au même rythme.

Lorsque la tension entre la grille G et l'émetteur E du transistor T1 devient inférieure à une tension seuil, le transistor T1 se bloque.

Le courant I passe alors dans la cinquième branche B5 reliée en parallèle du transistor et des première et deuxième branches et charge le condensateur $C_{SN2}$.

Lorsque la tension aux bornes du condensateur $C_{SN2}$ atteint le seuil de conduction du circuit de limitation de tension de la sixième branche B6, le courant est alors dévié dans la sixième branche B6 et le composant DZ2 limite la tension à un niveau inférieur ou égal au niveau supportable par le transistor T1.

De manière correspondante, la mise en conduction du transistor T1 est commandée par la mise en conduction du transistor T2.

Le fonctionnement du transistor T1 exposé ici est de type « saturé/bloqué », mais bien entendu il peut être commandé pour un fonctionnement linéaire.

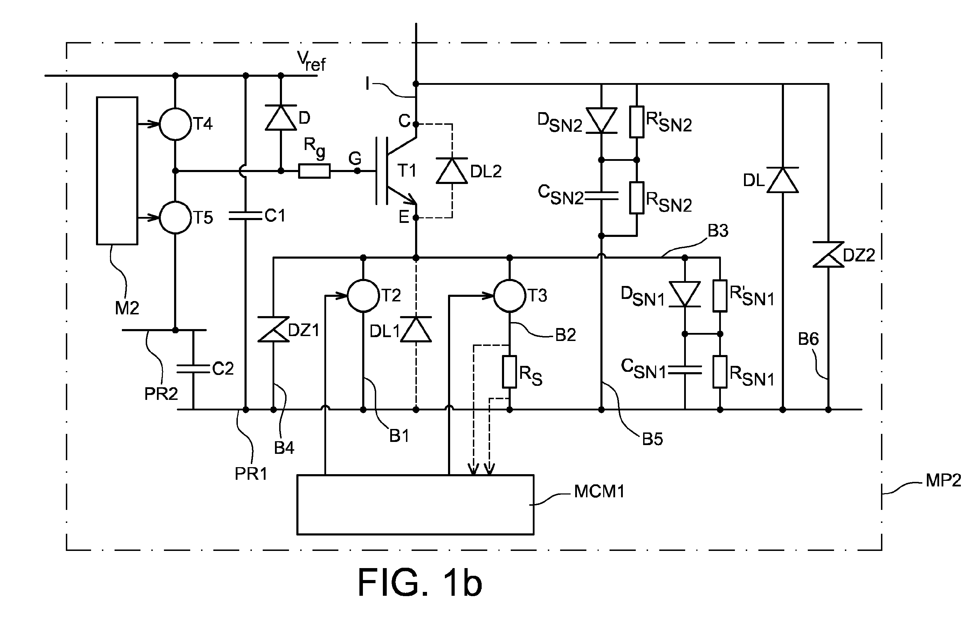

Selon un autre mode de réalisation représenté à la **figure 1b,** le transistor T1 fait partie d'un module de puissance MP2.

Par rapport au premier mode de réalisation représenté à la figure 1a, la grille G du transistor T1 n'est pas reliée directement à la tension de référence $V_{ref}$, mais elle est connectée, via une résistance optionnelle Rg, à la sortie d'un étage de commande de grille, constitué par des transistors T4 et T5, une diode D et un module de commande M2.

Entre un point à la tension de référence $V_{ref}$ et la résistance $R_g$, l'étage de commande de grille comporte le transistor T4 et la diode D connectée en parallèle. Entre un point de référence de tension PR2 et la résistance $R_g$, l'étage de commande de grille comporte le transistor T5. Le point de référence de tension PR2 est relié au point de référence de tension PR1 par l'intermédiaire d'un condensateur $C_2$.

Les transistors T4 et T5 ont un mode de fonctionnement de type « saturé / bloqué ». Lorsque le transistor T1 doit être conducteur, le transistor T4 est mis en conduction, reliant ainsi de façon quasi directe la grille G du transistor T1 à la tension de référence $V_{ref}$, et le transistor T5 est maintenu à l'état bloqué. Lorsque le transistor T1 doit être bloqué, le transistor T5 est mis en conduction, reliant ainsi de façon quasi directe la grille G du transistor T1 au point de tension de référence PR2, et le transistor T4 est maintenu à l'état bloqué.

Les autres constituants du module de puissance MP2 sont analogues à ceux du module de puissance MP1 précédemment décrits. Ils portent les mêmes références numériques et ne sont pas re-décrits.

Le module de commande et de mesure MCM1 des transistors T2 et T3 et le module de commande M2 des transistors T4 et T5 fonctionnent de manière synchrone. Ainsi, bien que, comme décrit précédemment, le module de commande et de mesure MCM1 des transistors T2 et T3 suffise à lui seul à assurer la mise en conduction ou la mise hors conduction du transistor T1, le module de commande M2 des transistors T4 et T5 permet d'obtenir des temps de commutation plus courts lors de la mise hors conduction du transistor T1.

Dans un mode de réalisation préférentiel, les points de référence de tension PR1 et PR2 sont confondus en un seul point PR1.

L'un des intérêts du principe ainsi illustré par la figure 1a et la figure 1b, est de ne pas nécessiter la présence d'une alimentation auxiliaire négative pour créer une polarisation inverse de la grille G du transistor T1, condition utile à son blocage rapide.

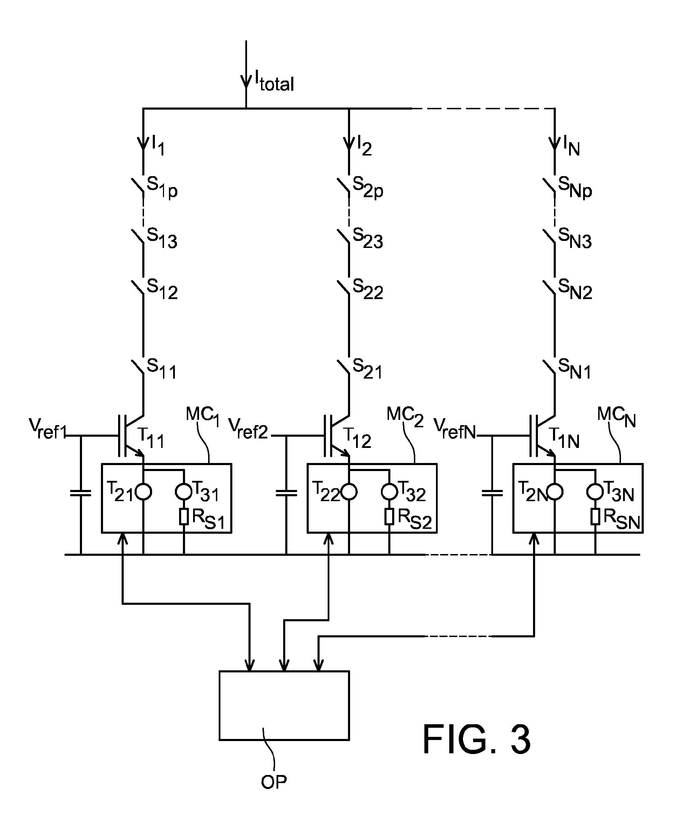

En référence à la **figure 3,** un dispositif d'équilibrage de courant dans des branches parallèles comportant chacune au moins un transistor est détaillé.

Le système comporte N branches principales parallèles. Chaque branche principale comporte P circuits électriques similaires montés en série. Les circuits électriques sont globalement des contacts électriques pouvant être ouverts ou fermés.

Ainsi la première branche principale comporte les contacts électriques $S_{11}$ à $S_{1P}$, la deuxième branche principale comporte les contacts électriques $S_{21}$ à $S_{2P}$, et ainsi de suite jusqu'à la Nième branche principale qui comporte les contacts électriques $S_{N1}$ à $S_{NP}$.

Chaque branche principale comporte un transistor $T_{11}$, respectivement $T_{12}$, ... $T_{1N}$ en série avec les contacts électriques. Chaque transistor $T_{11}$ à $T_{1N}$ est commandé par une tension de commande respective $V_{ref1}$ à $V_{refN}$. Chaque transistor $T_{11}$ à $T_{1N}$ est relié à un dispositif de mesure de courant respectif $MC_1$, $MC_2$, ..., $MC_N$, tel que décrit en référence aux figures 1a et 1b.

En outre, chaque transistor $T_{11}$ à $T_{1N}$ est relié aux différentes branches utiles pour la mesure de courant, telles que décrites en référence aux figures 1a et 1b. Pour simplifier la figure 3, seuls les transistors $T_{21}$, $T_{31}$, $T_{22}$, $T_{32}$, $T_{2N}$ et $T_{3N}$ et les résistances $R_{S1}$, $R_{S2}$ et $R_{SN}$ ont été représentés.

Les contacts électriques $S_{ij}$ étant tous fermés, un courant total $I_{total}$ est appliqué à l'ensemble des N branches principales. Une fraction $I_1$, $I_2$, ..., $I_N$ du courant total $I_{total}$ circule dans chacune des branches principales.

Pour simplifier l'écriture, le courant circulant dans la branche de rang i est noté $I_i$, l'indice i allant de 1 à N, N étant le nombre de branches principales. De façon similaire, les contacts électriques sont notés $S_{ij}$, l'indice j allant de 1 à P, P étant le nombre de contacts électriques d'une même branche.

Les contacts électriques $S_{ij}$ présentent respectivement une impédance d'insertion lorsqu'ils sont fermés. Cette impédance peut être assimilée à une résistance $R_{ij}$.

En pratique, pour des contacts électriques $S_{ij}$ identiques, les valeurs effectives des résistances $R_{ij}$ sont dispersées autour d'une valeur nominale.

Cette dispersion s'ajoute à celle des caractéristiques des transistors T1i.

Ainsi, même si les transistors $T_{11}$ à $T_{1N}$ sont pilotés de la même manière, les courants $I_1$ à $I_N$ dans les branches principales sont généralement différents d'une valeur moyenne $I_{moy}$ qui est la moyenne $I_{total}/N$.

Or, dans le cas où les courants sont importants au regard des capacités de transit des contacts, les échauffements de ces derniers peuvent aussi être dispersés et provoquer des dégradations de leurs performances.

Les dispositifs de mesure de courant respectif $MC_1$, $MC_2$, ..., $MC_N$, sont reliés à un organe de pilotage OP, tel qu'un ordinateur. L'organe de pilotage OP assure les fonctions suivantes :

- commande d'une mesure simultanée du courant de chaque branche,
- calcul d'un courant d'équilibre en fonction du courant mesuré dans chaque branche,
- comparaison entre une valeur représentative du courant mesuré dans chaque branche et le courant d'équilibre,
- pilotage des tensions de commande en fonction du résultat de la comparaison pour chaque branche.

Les dispositifs de mesure de courant respectif $MC_1$, $MC_2$, ..., $MC_N$, et l'organe de pilotage OP forment un mode de réalisation de dispositif d'équilibrage de courant.

Grâce à l'invention, le courant est équilibré dynamiquement dans chacun des transistors $T_{11}$ à $T_{1N}$, par l'adaptation de leur taux de conduction via l'ajustement de la valeur de chacune des tensions de commande $V_{refi}$ respectivement appliquées aux transistors $T_{11}$ à $T_{1N}$.

L'organe de pilotage OP assure également des fonctions de surveillance de circuits électriques, soit en combinaison avec l'équilibrage, soit de manière alternative. Il assure ainsi l'émission d'un signal d'anomalie en fonction du résultat de la comparaison pour chaque branche.

En pratique, un certain nombre de branches principales peuvent être mises hors service. Dans la suite, le nombre de branches principales restant en service est noté Ns.

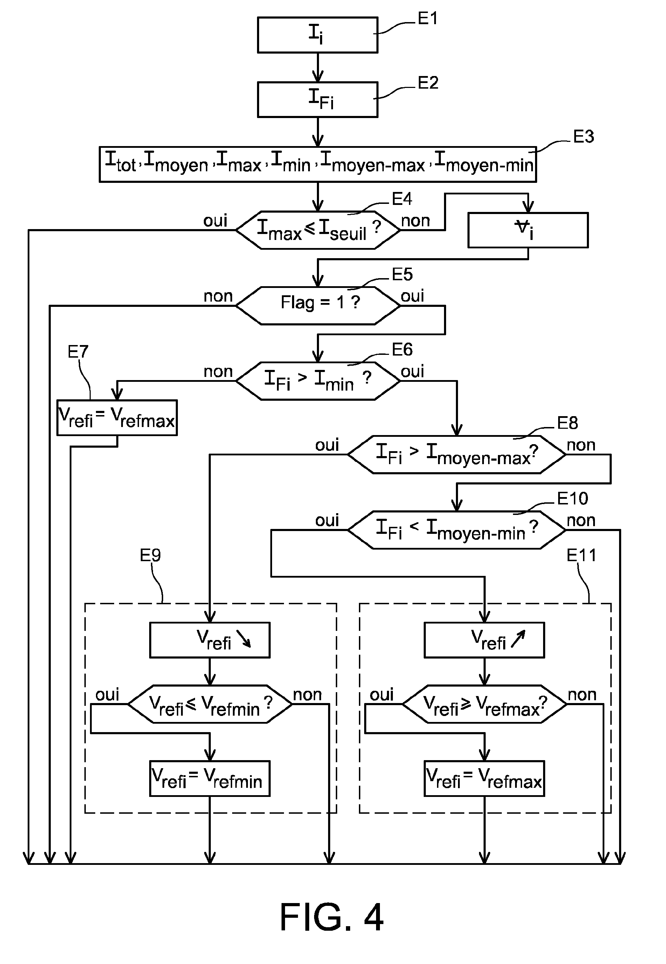

La **figure 4** représente le fonctionnement du dispositif d'équilibrage des courants sous la forme d'un algorithme comportant des étapes E1 à E11.

Avant que cet algorithme ne soit mis en application, les transistors T1i de chaque branche principale ont été mis en conduction, et par défaut, ils sont soumis à une même tension de commande $V_{ref\ init}$. Selon un mode de réalisation préférentiel, la tension de commande $V_{ref\ init}$ est égale à une tension de commande maximale $V_{refmax}$.

L'étape E1 est la mesure simultanée des courants dans chacune des N branches principales, par les dispositifs de mesure de courant $MC_1$ à $MC_N$. Cette mesure est effectuée comme précédemment exposée en référence aux figures 11, 1b, 2a et 2b. Les résultats des mesures effectuées sur chacune des N branches principales sont mémorisés par l'organe de pilotage OP qui dispose ainsi de la connaissance de tous les courants $I_i$.

L'étape suivante E2 est le calcul d'une valeur filtrée $I_{Fi}$ de chacun des courants $I_i$, via la mise en oeuvre, selon l'art courant, d'un algorithme F de filtrage numérique tenant compte des M valeurs antérieures de courant $I_{iantk}$ du courant $I_i$, et dont les constantes de temps sont adaptées aux constantes de temps électriques et thermiques de l'application :

$$I_{Fi} = F(I_i, I_{iant1}, I_{iant2}, \ldots I_{iantk}, \ldots I_{iantM})$$

L'étape suivante E3 est le calcul :

- D'une image $I_{tot}$ du courant total $I_{total}$. Le courant $I_{tot}$ est la somme de tous les courants $I_{Fi}$ dans chacune des Ns branches principales en service :

$$I_{tot} = \sum_{i=1}^{Ns} I_{Fi}$$

- Du courant moyen $I_{moyen}$ correspondant à un partage égal du courant $I_{tot}$ dans les Ns branches principales en service :

$$I_{moyen} = I_{tot} / Ns$$

- Du courant $I_{moyen-max}$ correspondant à la limite supérieure de la zone dans laquelle le courant $I_{Fi}$ est considéré comme sensiblement égal au courant moyen $I_{moyen}$. Le courant $I_{moyen-max}$ est calculé à partir du courant moyen $I_{moyen}$ et d'une valeur $\Delta I$ prédéterminée en fonction de l'application :

$$I_{moyen-max} = I_{moyen} + \Delta I$$

- Du courant $I_{moyen-min}$ correspondant à la limite inférieure de la zone dans laquelle le courant $I_{Fi}$ est considéré comme sensiblement égal au courant moyen $I_{moyen}$. Le courant $I_{moyen-min}$ est calculé à partir du courant moyen $I_{moyen}$ et d'une valeur $\Delta I$ prédéterminée en fonction de l'application :

$$I_{moyen-min} = I_{moyen} - \Delta I$$

- Du courant $I_{min}$, courant le plus petit parmi les Ns courants $I_{Fi}$, supposés tous positifs par convention de signe, et circulant dans les Ns branches principales en service :

$$I_{min} = min(I_{Fi})$$

- Du courant $I_{max}$, courant le plus grand parmi les N courants $I_{Fi}$, supposés tous positifs par convention de signe :

$$I_{max} = max(I_{Fi})$$

L'étape suivante E4 est une comparaison du courant $I_{max}$ calculé avec une valeur de référence $I_{seuil}$. La valeur de référence $I_{seuil}$ est prédéterminée en fonction de l'application et correspond à la valeur du courant d'une branche donnée en dessous de laquelle l'équilibrage des courants ne sera pas effectué, d'une part parce que les courants étant faibles, un éventuel déséquilibre est sans danger, et d'autre part parce que les imprécisions de mesure sont plus importantes pour les faibles courants que pour les forts courants.

Si le courant $I_{max}$ est inférieur au seuil $I_{seuil}$, alors les tensions de référence $V_{refi}$ de chacune des branches restent inchangées.

Si le courant $I_{max}$ est supérieur au seuil $I_{seuil}$, alors les étapes suivantes sont effectuées pour chacune des branches principales. On les décrit pour une branche principale donnée.

L'étape suivante E5 est un test pour déterminer si la branche principale considérée est en service ou hors service. A titre d'exemple, ce test peut être fait au moyen d'une variable Flag pouvant prendre la valeur 1 si branche principale considérée est en service et la valeur 0 dans le cas contraire.

Si la variable Flag est égale à 0, aucune action n'est entreprise et le traitement est alors terminé pour la branche considérée.

Si la variable Flag est égale à 1, l'étape E5 est suivie par l'étape E6, qui est la comparaison du courant $I_{Fi}$ de la branche principale donnée avec la valeur minimale de courant $I_{min}$ calculé précédemment et correspondant au courant le plus petit circulant dans l'une des N branches principales.

Si la valeur du courant $I_{Fi}$ est inférieure à la valeur $I_{min}$, cela signifie que la branche considérée a un taux de conduction inférieur à celui de toutes les autres branches principales. Alors l'étape E6 est suivie de l'étape E7 à laquelle la tension de référence $V_{refi}$ est mise à la valeur de tension de commande maximale $V_{refmax}$. Ainsi, lorsque le courant dans la branche considérée est le plus faible de toutes les branches principales, on commande la conduction maximale au transistor $T_{1i}$. Le traitement est alors terminé pour la branche considérée.

Si la valeur du courant $I_{Fi}$ est supérieure à la valeur $I_{min}$, alors l'étape E6 est suivie de l'étape E8 à laquelle la valeur du courant $I_{Fi}$ est comparée à la valeur $I_{moyen-max}$, limite supérieure de la zone dans laquelle le courant $I_{Fi}$ est considéré comme sensiblement égal au courant moyen $I_{moyen}$ calculé à l'étape E3.

Si la valeur du courant $I_{Fi}$ est supérieure à la valeur $I_{moyen-max}$, cela signifie que la branche considérée a un taux de conduction supérieur au taux de conduction moyen de toutes les autres branches principales. Alors l'étape E8 est suivie de l'étape E9 à laquelle la tension de référence $V_{refi}$ est diminuée, sans toutefois devenir inférieure à une valeur minimale prédéterminée $V_{refmin}$. Par exemple, la tension de référence $V_{refi}$ est diminuée d'une valeur prédéterminée. Ainsi, le courant dans la branche considérée va diminuer et se rapprocher de la valeur du courant moyen $I_{moyen}$. Le traitement est alors terminé pour la branche considérée.

Si la valeur du courant $I_{Fi}$ est inférieure à la valeur $I_{moyen-max}$, alors l'étape E8 est suivie de l'étape E10 à laquelle la valeur du courant $I_{Fi}$ est comparée à la valeur $I_{moyen-min}$, limite inférieure de la zone dans laquelle le courant $I_{Fi}$ est considéré comme sensiblement égal au courant moyen $I_{moyen}$ calculé à l'étape E3.

Si la valeur du courant $I_{Fi}$ est supérieure ou égale à la valeur $I_{moyen-min}$, cela signifie que le courant $I_{Fi}$ est considéré comme sensiblement égal au courant moyen $I_{moyen}$ calculé à l'étape E3. Alors la tension de référence $V_{refi}$ n'est pas modifiée et le traitement est terminé pour la branche considérée.

Si la valeur du courant $I_{Fi}$ est inférieure à la valeur $I_{moyen-min}$, alors l'étape E10 est suivie de l'étape E11 à laquelle la tension de référence $V_{refi}$ est augmentée, sans toutefois devenir supérieure à la valeur maximale prédéterminée $V_{refmax}$. Par exemple, la tension de référence $V_{refi}$ est augmentée d'une valeur prédéterminée, identique à celle utilisée à l'étape E9. Ainsi, le courant dans la branche considérée va se rapprocher de la valeur du courant moyen $I_{moyen}$. Le traitement est alors terminé pour la branche considérée.

Le principe est donc d'augmenter le taux de conduction des branches principales pour lesquelles le courant mesuré est au-dessous du courant moyen, de diminuer le taux de conduction des branches principales pour lesquelles le courant mesuré est au-dessus du courant moyen, et de ne pas changer le taux de conduction des branches pour lesquelles le courant mesuré est jugé peu différent du courant moyen.

En variante, il est possible de seulement augmenter le taux de conduction des branches principales pour lesquelles le courant mesuré est au-dessous du courant moyen ou encore de seulement augmenter le taux de conduction de la branche pour laquelle le courant mesuré est au-dessous du courant moyen et est le plus faible des courants mesurés.

Selon une autre variante de réalisation, il est possible de commander la conduction maximale à la branche ayant le plus faible courant, et de diminuer la tension de commande du transistor de la branche ayant le plus fort courant.

Selon un mode de réalisation préférentiel, les tensions de commande des transistors $T_i$ sont choisies au sein d'une table contenant un nombre entier de valeurs prédéterminées, comprises entre les valeurs limites $V_{refmin}$ et $V_{refmax}$, bornes incluses. Ces valeurs de tension de commande prédéterminées sont respectivement associées à des indices $Index_i$ qui sont des nombres entiers, compris entre deux limites $Index_{min}$ et $Index_{max}$, bornes incluses.

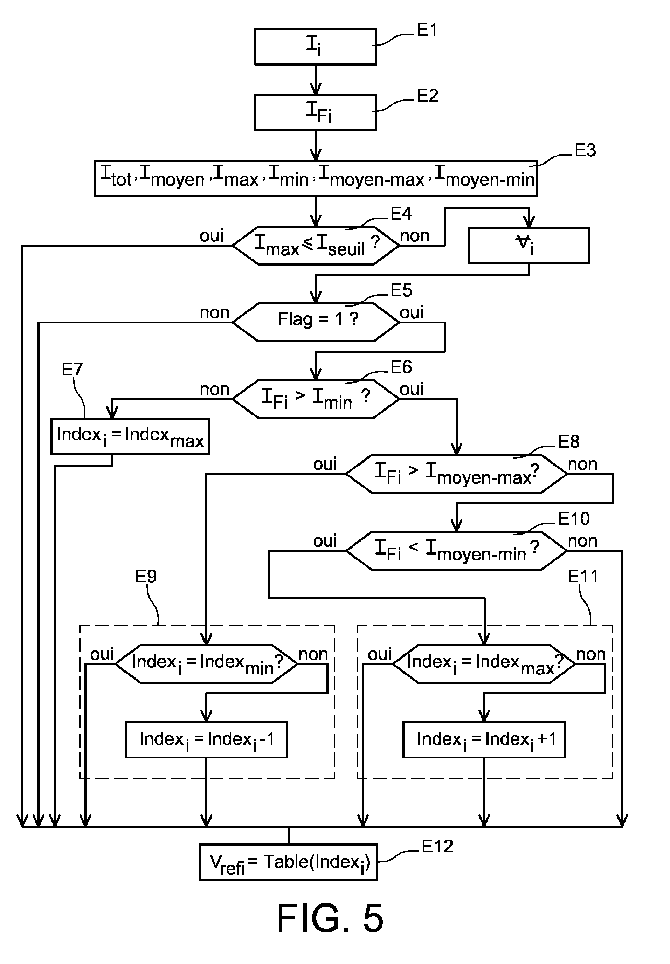

Ce mode de réalisation est illustré à la **figure 5** sous la forme d'un algorithme comportant les étapes E1 à E12. Les étapes E1 à E11 sont similaires à celles décrites en référence à la figure 4, sauf que les étapes E7, E9 et E11 permettent de sélectionner un indice $Index_i$. L'étape E12 permet ensuite de régler la valeur de la tension de commande $V_{refi}$ à la valeur prédéterminée désignée dans la table par l'indice $Index_i$.

Quel que soit le mode de réalisation, l'équilibrage des courants est effectué périodiquement. Les étapes E1 à E11 ou E1 à E12, selon le mode de réalisation, sont donc répétées.

Pour des courants continus, la périodicité des mesures est fixée, en respect des critères classiques des systèmes échantillonnés, en fonction des constantes de temps électriques et thermiques de l'application.

Pour des courants alternatifs, les transistors de chaque branche ne sont traversés par un courant que pendant la demi-période où les courants sont positifs. Pendant l'autre demi-période, aucun courant ne traverse les transistors et les courants s'écoulent dans les diodes de roue-libre (non représentées à la figure 3). La mesure des courants peut alors être effectuée via des moyens plus conventionnels tels que des transformateurs de courant. Néanmoins, dans beaucoup d'applications mettant en jeu des courants alternatifs, ceux-ci sont de nature périodique. C'est par exemple le cas des réseaux de transport et de distribution de l'énergie électrique. La méthode décrite dans la présente demande pour les courants continus est alors toujours applicable aux courants alternatifs moyennant le respect de conditions supplémentaires.

La mesure des courants doit être effectuée pendant la demi-période où les courants sont positifs, cette convention de signe signifiant que le courant est positif s'il transite par les transistors $T_{1i}$, et négatif s'il transite par les diodes de roue libre. En outre, la mesure simultanée des courants dans les branches principales est de préférence effectuée au voisinage de la valeur maximale du courant, ce qui permet une meilleure précision dans l'évaluation du taux de répartition du courant total dans les branches principales.

Les mesures des courants $I_i$ sont alors effectuées en synchronisme avec un signal de synchronisation lui-même élaboré à partir d'une mesure du courant $I_{total}$ et de l'asservissement d'un oscillateur local via une boucle à verrouillage de phase, réglée de façon que le signal de synchronisation délivre des fronts de commutation lorsque le courant $I_{total}$ est proche de sa valeur maximale.

Lorsque ces conditions sont respectées, l'algorithme décrit pour les courants continus et illustré par les figures 4 et 5 est applicable aux courants alternatifs périodiques.

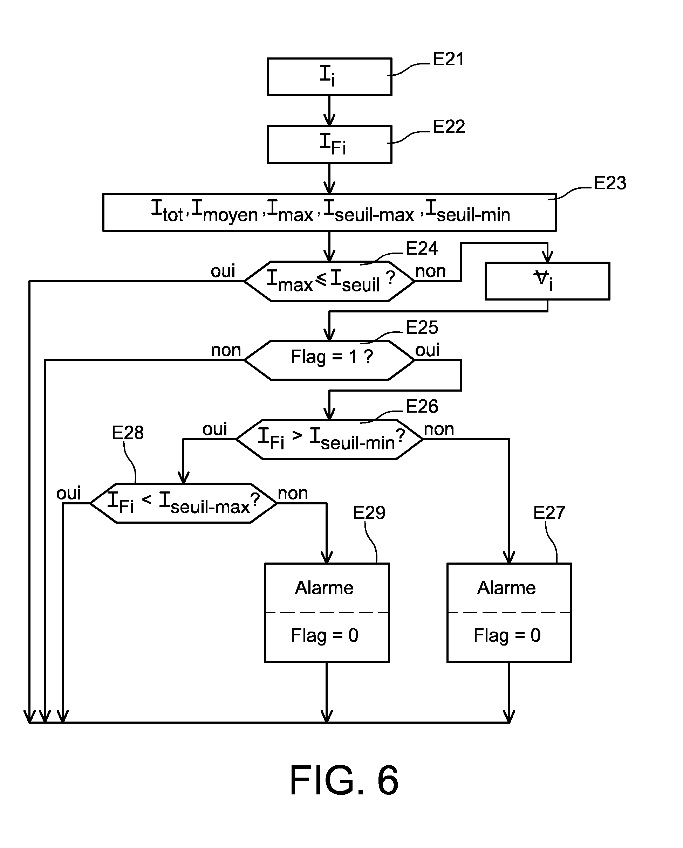

En référence à la **figure 6,** un procédé de surveillance des constituants des branches principales, et tout particulièrement des contacts électriques, comporte des étapes E21 à E29. Ce procédé dérive du procédé d'équilibrage des courants exposé plus haut et est mis en oeuvre dans le dispositif de la figure 3.

Avant que cet algorithme ne soit mis en application, les transistors T1i de chaque branche principale ont été mis en conduction, et par défaut, ils sont soumis à la même tension de commande $V_{ref\,init}$. Selon un mode de réalisation préférentiel, la tension de commande $V_{ref\,init}$ est égale à la tension de commande maximale $V_{refmax}$.

L'étape E21 est la mesure simultanée des courants dans chacune des N branches principales. Cette mesure est effectuée comme précédemment exposé. Les résultats des mesures effectuées sur chacune des N branches principales sont mémorisés et transmis à l'organe de pilotage OP qui dispose ainsi de la connaissance de tous les courants $I_i$.

L'étape suivante E22 est le calcul de la valeur filtrée $I_{Fi}$ du courant $I_i$, via la mise en oeuvre, selon l'art courant, d'un algorithme F de filtrage numérique tenant compte des M valeurs antérieures $I_{iantk}$ du courant $I_i$, et dont les constantes de temps sont adaptées aux constantes de temps électriques et thermiques de l'application :

$$I_{Fi} = F(I_i,\ I_{iant1},\ I_{iant2}, \ldots I_{iantk}, \ldots I_{iantM})$$

L'étape suivante E23 est le calcul :

- D'une image $I_{tot}$ du courant total $I_{total}$. Le courant $I_{tot}$ est la somme de tous les courants $I_{Fi}$ dans chacune des N branches principales :

$$I_{tot} = \sum_{i=1}^{N} I_{Fi}$$

- Du courant moyen $I_{moyen}$ correspondant à un partage égal du courant dans les Ns branches principales en service :

$$I_{moyen} = I_{tot} / Ns$$

- Du courant $I_{seuil-max}$ correspondant à la limite supérieure de la dispersion acceptable des courants entre branche, et au-delà de laquelle la branche principale concernée est considérée en défaut. Une telle situation pourrait par exemple être la conséquence d'un court-circuit dans la branche principale considérée. Le courant $I_{seuil-max}$ est calculé à partir du courant moyen $I_{moyen}$ et d'un facteur de dispersion $\alpha_{max}$ prédéterminée en fonction de l'application :

$$I_{seuil-max} = I_{moyen}.(1+ \alpha_{max})$$

- Du courant $I_{seuil-min}$ correspondant à la limite inférieure de la dispersion acceptable des courants entre branche, et en deçà de laquelle la branche principale concernée est considérée en défaut, son courant étant trop faible par comparaison avec les autres branches principales. Une telle situation pourrait par exemple être la conséquence de la défaillance d'au moins un des contacts électriques de la branche principale considérée. Le courant $I_{seuil-min}$ est calculé à partir du courant moyen $I_{moyen}$ et d'un facteur de dispersion $\alpha_{min}$ prédéterminée en fonction de l'application :

$$I_{seuil-min} = I_{moyen}.(1- \alpha_{min})$$

- Du courant $I_{max}$, courant le plus grand parmi les N courants $I_{Fi}$, supposés tous positifs par convention de signe.

$$I_{max} = max(I_{Fi})$$

L'étape suivante E24 est la comparaison du courant $I_{max}$ à une valeur de référence $I_{seuil}$. La valeur de référence $I_{seuil}$ est prédéterminée en fonction de l'application et correspond à la valeur du courant d'une branche donnée en dessous de laquelle la surveillance des courants ne sera pas effectué, d'une part parce que les courants étant faibles, une éventuelle défaillance est sans danger, et d'autre part parce que les imprécisions de mesure sont plus importantes pour les faibles courants que pour les forts courants.

Si le courant $I_{max}$ est inférieur au seuil $I_{seuil}$, alors aucune alarme n'est émise. Le traitement est alors terminé pour la branche considérée.

Si le courant $I_{max}$ est supérieur au seuil $I_{seuil}$, alors les étapes suivantes sont effectuées pour chacune des branches principales. On les décrit pour une branche principale donnée.

L'étape suivante E25 est un test pour déterminer si la branche principale considérée est en service ou hors service. A titre d'exemple, ce test peut être fait au moyen d'une variable Flag pouvant prendre la valeur 1 si la branche principale considérée est en service et la valeur 0 dans le cas contraire.

Si la variable Flag est égale à 0, aucune action n'est entreprise et le traitement est alors terminé pour la branche considérée.

Si la variable Flag est égale à 1, l'étape E25 est suivie par l'étape E26, qui est la comparaison du courant $I_{Fi}$ de la branche principale donnée avec la valeur seuil de courant $I_{seuil-min}$ calculée précédemment.

Si la valeur du courant $I_{Fi}$ est inférieure à la valeur $I_{seuil-min}$, cela signifie que la branche considérée a un taux de conduction anormalement faible par rapport à celui des autres branches principales. Alors l'étape E26 est suivie de l'étape E27 à laquelle une signalisation appropriée au défaut constaté est télétransmise à un système de supervision. Selon un mode de réalisation, la branche principale concernée peut être mise hors service, par exemple via le blocage du transistor $T_{1i}$, et la variable Flag est alors positionnée à la valeur 0. Une telle action peut par exemple éviter la dégradation des contacts électriques de la branche principale concernée. Le courant devant normalement circuler dans cette branche principale est alors réparti dans les branches principales n'étant pas signalées en anomalie. Cela suppose que le nombre de branches principales est suffisant pour accepter un mode de fonctionnement dit « dégradé » dans lequel une ou plusieurs branches principales sont hors service. Le traitement est alors terminé pour la branche considérée.

Si la valeur du courant $I_{Fi}$ est supérieure à la valeur $I_{seuil-min}$, alors l'étape E26 est suivie de l'étape E28 à laquelle la valeur du courant $I_{Fi}$ est comparée à la valeur seuil $I_{seuil-max}$, calculée précédemment.

Si la valeur du courant $I_{Fi}$ est supérieure à la valeur $I_{seuil-max}$, cela signifie que la branche considérée a un taux de conduction anormalement élevé par rapport à celui des autres branches principales. Alors l'étape E28 est suivie de l'étape E29 à laquelle une signalisation appropriée au défaut constaté est télétransmise à un système de supervision. Selon un mode de réalisation, la branche principale concernée peut être mise hors service, par exemple via le blocage du transistor $T_{1i}$, et la variable Flag est alors positionnée à la valeur 0. Une telle action peut par exemple éviter la dégradation des contacts électriques ou du transistor $T_{1i}$ de la branche principale concernée. Le courant devant normalement circuler dans cette branche principale est alors réparti dans les branches principales n'étant pas signalées en anomalie. Cela suppose que le nombre de branches principales est suffisant pour accepter un mode de fonctionnement dit « dégradé » dans lequel une ou plusieurs branches principales sont hors service. Le traitement est alors terminé pour la branche considérée.

Si la valeur du courant $I_{Fi}$ est inférieure à la valeur $I_{seuil-max}$, cela signifie que la branche considérée n'est pas en anomalie. Alors aucune alarme n'est émise. Le traitement est alors terminé pour la branche considérée.

La surveillance des constituants des branches principales est effectuée périodiquement. Les étapes E21 à E29 sont donc répétées.

Le principe est donc de détecter les branches principales pour lesquelles le courant mesuré est soit très au-dessous du courant moyen soit très au-dessus du courant moyen, et de signaler ces branches comme étant en anomalie.

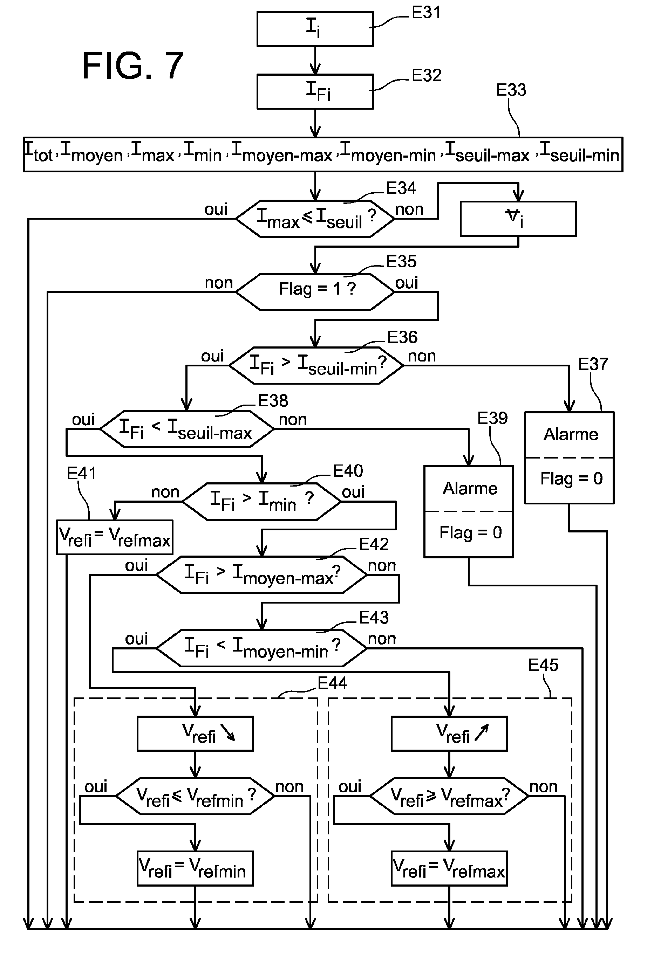

Les algorithmes d'équilibrage de courant et de surveillance des constituants des branches principales décrits précédemment peuvent être fusionnés en un seul algorithme, représenté à la **figure 7.** Ce procédé est appliqué au circuit de la figure 3. Il comporte des étapes E31 à E45 similaires à celles décrites en référence aux figures 4 et 6.

Par exemple, les étapes E44 et E45 sont similaires aux étapes E9 et E11 d'équilibrage des courants dans les branches principales. De même, les étapes E37 et E39 sont similaires aux étapes E27 et E29 de surveillance des constituants des branches principales.

Ces étapes sont réalisées à partir de l'étape E31 de mesures des courants dans les branches principales. L'étape E31 est similaire aux étapes E1 et E21 précédemment décrites.

La présente invention s'applique par exemple dans le dispositif disjoncteur mécatronique décrit et revendiqué dans FR 11 62413. Plus précisément, la présente invention peut être utilisée pour les transistors de puissance 101a et 101b représentés aux figures 2, 5, 5A, 6A et 7 de ce document.

Il est à noter que l'équilibrage de courant selon la présente invention peut s'appliquer à différents niveaux. Par exemple, l'équilibrage peut être réalisé entre les modules principaux 10.1, 10.2, 10.3 représentés à la figure 1 de FR11 62413. L'équilibrage peut aussi être réalisé entre les sous-branches 10.11, 10.12, 10.13, 10.1n du module 10.1, représenté à la figure 5 de ce document.

**Revendications**

1. Dispositif de mesure d'un courant de charge traversant au moins un transistor (T1),
   **caractérisé en ce qu'**il comporte :

   - une première branche (B1) reliée entre une électrode de sortie de l'au moins un transistor et un point de référence de tension (PR1), la première branche comportant au moins un premier transistor de commande (T2),
   - une deuxième branche (B2) reliée en parallèle de la première branche, la deuxième branche (B2) comportant au moins un deuxième transistor de commande (T3) en série avec un circuit de mesure de courant ($R_s$).

2. Dispositif de mesure d'un courant de charge selon la revendication 1, **caractérisé en ce qu'**il comporte en outre :

   - une troisième branche (B3) reliée en parallèle des première et deuxième branches, la troisième branche (B3) comportant au moins un condensateur ($C_{SN1}$), au moins une diode ($D_{SN1}$) et au moins une résistance ($R_{SN1}$, $R'_{SN1}$).

3. Dispositif de mesure d'un courant de charge selon la revendication 1 ou 2,
   **caractérisé en ce qu'**il comporte en outre :

- une quatrième branche (B4) reliée en parallèle des première et deuxième branches, la quatrième branche comportant un circuit de limitation de tension (DZ1).

4. Dispositif de mesure d'un courant de charge selon l'une quelconque des revendications 1 à 3, **caractérisé en ce qu'**il comporte en outre :

    - une cinquième branche (B5) reliée en parallèle de l'ensemble formé par l'au moins un transistor (T1) et les branches qui lui sont connectées en série, la cinquième branche (B5) comportant au moins un condensateur ($C_{SN2}$), une diode ($D_{SN2}$) et au moins une résistance ($R_{SN2}$, $R'_{SN2}$).

5. Dispositif de mesure d'un courant de charge selon l'une quelconque des revendications 1 à 4, **caractérisé en ce qu'**il comporte en outre :

    - une sixième branche (B6) reliée en parallèle de l'ensemble formé par l'au moins un transistor (T1) et les branches qui lui sont connectées en série, la sixième branche (B6) comportant un circuit de limitation de tension (DZ2).

6. Dispositif de mesure d'un courant de charge selon l'une quelconque des revendications 1 à 5, **caractérisé en ce qu'**il comporte en outre :

    - au moins une diode de roue libre (DL) reliée en parallèle de l'ensemble formé par l'au moins un transistor (T1) et les branches qui lui sont connectées en série.

7. Dispositif d'équilibrage de courant dans des branches parallèles comportant chacune un transistor ($T_{11}$, $T_{12}$, $T_{1N}$), chaque transistor étant commandé par une tension de commande respective ($V_{ref1}$, $V_{ref2}$, $V_{refN}$), **caractérisé en ce qu'**il comporte :

    - un dispositif de mesure d'un courant de charge selon l'une quelconque des revendications 1 à 5, respectivement associé à chaque branche,
    - un moyen de commande d'une mesure simultanée du courant ($I_1$, $I_2$, $I_N$) de chaque branche,
    - un moyen de calcul d'un courant d'équilibre ($I_{moyen}$) en fonction du courant mesuré dans chaque branche,
    - un moyen de comparaison entre une valeur représentative du courant mesuré dans chaque branche et le courant d'équilibre,
    - un moyen de pilotage des tensions de commande en fonction du résultat de la comparaison pour chaque branche.

8. Dispositif d'équilibrage de courant dans des branches parallèles selon la revendication 7, le courant étant alternatif, **caractérisé en ce qu'**il comporte :

    - un moyen de synchronisation adapté à commander la mesure de courant de chaque branche à un instant voisin d'un extrémum de courant.

9. Dispositif de surveillance de circuits électriques dans des branches parallèles comportant chacune un transistor, chaque transistor étant commandé par une tension de commande respective, **caractérisé en ce qu'**il comporte :

    - un dispositif de mesure d'un courant de charge selon l'une quelconque des revendications 1 à 5, respectivement associé à chaque branche,
    - un moyen de commande d'une mesure simultanée du courant ($I_1$, $I_2$, $I_N$) de chaque branche,
    - un moyen de calcul d'un courant d'équilibre ($I_{moyen}$) en fonction du courant mesuré dans chaque branche,
    - un moyen de comparaison entre une valeur représentative du courant mesuré dans chaque branche et le courant d'équilibre,
    - un moyen d'émission d'un signal d'anomalie en fonction du résultat de la comparaison effectuée par le moyen de comparaison.

10. Procédé de mesure d'un courant de charge traversant au moins un transistor (T1), **caractérisé en ce qu'**il comporte les étapes de :

- blocage (E100) d'au moins un premier transistor de commande (T2) inclus dans une première branche (B1) reliée entre une électrode de sortie du transistor (T1) et un point de référence de tension, au moins un deuxième transistor (T3) de commande dans une deuxième branche (B2) reliée en parallèle de la première branche étant préalablement en conduction,
- mesure (E101) du courant traversant la deuxième branche, par un circuit de mesure de courant relié en série avec l'au moins un deuxième transistor de commande de la deuxième branche, et
- mise en conduction (E102) de l'au moins un premier transistor de commande (T2) de la première branche.

11. Procédé de mesure d'un courant de charge traversant au moins un transistor (T1),
**caractérisé en ce qu'**il comporte les étapes de :

- mise en conduction (E200) d'au moins un deuxième transistor de commande (T3) dans une deuxième branche (B2) reliée entre une électrode de sortie du transistor (T1) et un point de référence de tension,
- blocage (E200) d'au moins un premier transistor de commande (T2) inclus dans une première branche (B1) reliée en parallèle de la deuxième branche,
- mesure (E201) du courant traversant la deuxième branche (B2), par un circuit de mesure de courant relié en série avec l'au moins un deuxième transistor de commande de la deuxième branche,
- mise en conduction (E202) de l'au moins un premier transistor de commande (T2) de la première branche, et
- blocage (E202) de l'au moins un deuxième transistor de commande (T3) de la deuxième branche.

12. Procédé d'équilibrage de courant dans des branches parallèles comportant chacune un transistor, chaque transistor étant commandé par une tension de commande respective,
**caractérisé en ce qu'**il comporte les étapes de :

- commande (E1) d'une mesure simultanée du courant de chaque branche, selon le procédé de mesure selon la revendication 10 ou 11, respectivement appliqué à chaque branche,
- calcul (E3) d'un courant d'équilibre en fonction du courant mesuré dans chaque branche,
- comparaison (E8, E10) entre une valeur représentative du courant mesuré dans chaque branche et le courant d'équilibre,
- pilotage (E9, E11) des tensions de commande en fonction du résultat de la comparaison pour chaque branche.

13. Procédé de surveillance de circuits électriques dans des branches parallèles comportant chacune un transistor, chaque transistor étant commandé par une tension de commande respective,
**caractérisé en ce qu'**il comporte les étapes de :

- commande (E21) d'une mesure simultanée du courant de chaque branche, selon le procédé de mesure selon la revendication 10 ou 11, respectivement appliqué à chaque branche,
- calcul (E23) d'un courant d'équilibre en fonction du courant mesuré dans chaque branche,
- comparaison (E26, E28) entre une valeur représentative du courant mesuré dans chaque branche et le courant d'équilibre,
- émission (E27, E29) d'un signal d'anomalie en fonction du résultat de la comparaison effectuée par le moyen de comparaison.

14. Programme d'ordinateur comportant des instructions pour l'exécution des étapes du procédé selon l'une quelconque des revendications 10 à 13 lorsque ledit programme est exécuté par un ordinateur.

15. Support d'enregistrement lisible par un ordinateur sur lequel est enregistré un programme d'ordinateur comprenant des instructions pour l'exécution des étapes du procédé selon l'une quelconque des revendications 10 à 13.

16. Circuit logique programmable paramétré de façon à exécuter des instructions pour l'exécution des étapes du procédé selon l'une quelconque des revendications 10 à 13.

FIG. 1a

FIG. 1b

FIG. 2a

FIG. 2b

FIG. 3

FIG. 4

FIG. 5

FIG. 6

# FIG. 7

```
┌─────────┐
│   Iᵢ    │─── E31
└─────────┘
     │
     ▼
┌─────────┐
│  I_Fi   │─── E32
└─────────┘
```

$$I_{tot}, I_{moyen}, I_{max}, I_{min}, I_{moyen-max}, I_{moyen-min}, I_{seuil-max}, I_{seuil-min}$$ ─── E33

oui ◄── $I_{max} \leqslant I_{seuil}$ ? ── E34 ── non ──► $\forall_i$

non ◄── Flag = 1 ? ── E35 ── oui

oui ◄── $I_{Fi} > I_{seuil-min}$? ── E36 ── non ──► E37

E38 — oui ◄── $I_{Fi} < I_{seuil-max}$ ── non ──► E39

**Alarme**
Flag = 0  (E37)

**Alarme**
Flag = 0  (E39)

E41 — $V_{refi} = V_{refmax}$

non ◄── $I_{Fi} > I_{min}$ ? ── E40 ── oui

oui ◄── $I_{Fi} > I_{moyen-max}$? ── E42 ── non

oui ◄── $I_{Fi} < I_{moyen-min}$ ? ── E43 ── non

E44 | E45

$V_{refi} \searrow$ | $V_{refi} \nearrow$

oui ◄── $V_{refi} \leqslant V_{refmin}$ ? ── non | oui ◄── $V_{refi} \geqslant V_{refmax}$? ── non

$V_{refi} = V_{refmin}$ | $V_{refi} = V_{refmax}$

**Europäisches Patentamt**
**European Patent Office**
**Office européen des brevets**

# RAPPORT DE RECHERCHE EUROPEENNE

Numéro de la demande

EP 15 16 3750

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | YANG ZHANG ET AL: "On-line calibration of lossless current sensing", 2004 IEEE APPLIED POWER ELECTRONICS CONFERENCE AND EXPOSITION, APEC 04, IEEE, ANAHEIM, CA, USA, vol. 2, 22 février 2004 (2004-02-22), pages 1345-1350, XP010703742, DOI: 10.1109/APEC.2004.1295997 ISBN: 978-0-7803-8269-5 * abrégé; figures 1,2,5 * * page 1345, colonne 2, alinéa Starting with "In this paper..." - page 1346, alinéas II, B * * page 1347, alinéa III - page 1348, alinéa IV * | 1-16 | INV. G01R17/06 G01R19/00 |
| X | US 2013/193992 A1 (KATO YUJI [JP]) 1 août 2013 (2013-08-01) * abrégé; figures 3-7 * * alinéa [0054] - alinéa [0060] * * alinéa [0068] - alinéa [0072] * * alinéas [0002], [0013] - [0017] * | 1-16 | |
| A | US 2008/265871 A1 (UMANS STEPHEN D [US]) 30 octobre 2008 (2008-10-30) * abrégé; figure 4 * * alinéas [0002] - [0003], [0011], [0013] - [0016], [0018], [0022] - [0024], [0027] * | 1-16 | **DOMAINES TECHNIQUES RECHERCHES (IPC)** G01R |
| A | US 5 616 970 A (DITTRICH ANDREAS [CH]) 1 avril 1997 (1997-04-01) * colonne 8, ligne 47 - colonne 8, ligne 66; figure 13 * | 1-16 | |

-/--

Le présent rapport a été établi pour toutes les revendications

| Lieu de la recherche | Date d'achèvement de la recherche | Examinateur |
|---|---|---|
| Munich | 21 septembre 2015 | Maric, Viktor |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

Europäisches
Patentamt

European
Patent Office

Office européen
des brevets

# RAPPORT DE RECHERCHE EUROPEENNE

Numéro de la demande

EP 15 16 3750

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 5 889 663 A (TABATA MASAFUMI [JP] ET AL) 30 mars 1999 (1999-03-30) <br> * abrégé; figures 1-2 * <br> * colonne 3, ligne 22 - colonne 3, ligne 41 * <br> * colonne 4, ligne 40 - colonne 5, ligne 59 * <br> ----- | 1-16 | |
| A | BORTIS D ET AL: "Active Gate Control for Current Balancing of Parallel-Connected IGBT Modules in Solid-State Modulators", IEEE TRANSACTIONS ON PLASMA SCIENCE, IEEE SERVICE CENTER, PISCATAWAY, NJ, US, vol. 36, no. 5, 1 octobre 2008 (2008-10-01), pages 2632-2637, XP011237226, ISSN: 0093-3813, DOI: 10.1109/TPS.2008.2003971 <br> * alinéa [00II] - alinéas [0III] - [000B]; figures 5,8 * <br> ----- | 1-16 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| Munich | 21 septembre 2015 | Maric, Viktor |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 15 16 3750

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-09-2015

| Document brevet cité au rapport de recherche | | | Date de publication | Membre(s) de la famille de brevet(s) | | | Date de publication |
|---|---|---|---|---|---|---|---|
| US 2013193992 | A1 | | 01-08-2013 | JP<br>US | 2013152181<br>2013193992 | A<br>A1 | 08-08-2013<br>01-08-2013 |
| US 2008265871 | A1 | | 30-10-2008 | AUCUN | | | |
| US 5616970 | A | | 01-04-1997 | AT<br>CA<br>CN<br>DE<br>EP<br>ES<br>JP<br>JP<br>US | 205978<br>2140575<br>1117670<br>4403941<br>0666647<br>2164749<br>3565933<br>H07264028<br>5616970 | T<br>A1<br>A<br>A1<br>A1<br>T3<br>B2<br>A<br>A | 15-10-2001<br>09-08-1995<br>28-02-1996<br>10-08-1995<br>09-08-1995<br>01-03-2002<br>15-09-2004<br>13-10-1995<br>01-04-1997 |
| US 5889663 | A | | 30-03-1999 | DE<br>JP<br>JP<br>US | 19821195<br>3267189<br>H10323016<br>5889663 | A1<br>B2<br>A<br>A | 14-01-1999<br>18-03-2002<br>04-12-1998<br>30-03-1999 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1162413